# EUROPÄISCHE PATENTSCHRIFT

(11) **EP 1 194 026 B1**
(45) Veröffentlichungstag und Bekanntmachung des Hinweises auf die Patenterteilung: **22.03.2006**
(21) Anmeldenummer: 01122092.8
(22) Anmeldetag: 14.09.2001
(51) Int. Cl.: H05K 5/00

(54) **Elektronikgehäusesystem**
Electronic housing system
Système pour boîtier électronique

(30) Priorität: 28.09.2000 DE 10049218
(43) Veröffentlichungstag der Anmeldung: 03.04.2002
(73) Patentinhaber: PHOENIX CONTACT GmbH & Co. Kg, 32825 Blomberg (DE); KEBA AG, 4041 Linz (AT)
(72) Erfinder: Quardt, Dirk, Dipl.-Ing., 32816 Schieder-Schwalenberg (DE); Söfker, Jörg, Dipl.-Ing., 32657 Lemgo (DE); Starzinger, Reinhard Gottlieb, Ing., 4861 Schörfling a. A. (AT); Wintersteiger, Hans Peter, Ing., 4232 Hagenberg (AT)
(74) Vertreter: Gesthuysen, von Rohr & Eggert

(56) Entgegenhaltungen:
- DE-A- 3 907 412
- DE-U- 1 871 657

## Beschreibung

Die Erfindung betrifft ein Elektronikgehäusesystem mit mindestens drei, insbesondere scheibenförmigen, auf einer Tragschiene aufrastbaren. Elektronikgehäusen, mit einem Verriegelungssystem zur Verriegelung der einzelnen Elektronikgehäuse, bestehend aus mindestens zwei Gehäusestücken, nämlich einem in dem ersten Elektronikgehäuse angeordneten Anfangsstück und einem in einem zweiten Elektronikgehäuse angeordneten Endstück, und aus einem Schlüsselelement, wobei das Anfangsstück als Schlüsselaufnahme und das Endstück als Schloß ausgebildet ist und die beiden Gehäusestücke durch eine Drehung des Schlüsselelements in dem Endstück miteinander verriegelbar sind.

Mit dem Trend zur Dezentralisierung von Elektronik direkt in den Prozeß sowie der Miniaturisierung von Elektronikbaugruppen zu kompakten, montagefreundlichen elektronischen Geräten werden zunehmend geeignete Elektronikgehäuse benötigt, wobei in der Regel dann auch die Anschlußtechnik in das Elektronikgehäuse integriert ist. Die einzelnen Elektronkigehäuse werden dabei bevorzugt auf einer Tragschiene aufgerastet und über ein Bus-System miteinander und mit einer Steuerung verbunden.

Hierbei gibt es nun je nach Anwendungsfall eine Vielzahl von unterschiedlichen Gehäuseformen, die sich in ihrer Größe, ihrem Aufbau und ihrer Funktion unterscheiden. Gemeinsam ist all diesen Elektronikgehäusen, daß in ihrem Inneren elektronische Baugruppen, meist in Form von Leiterplatten, angeordnet sind, welche durch das Elektronikgehäuse vor Berührung und Schmutz geschützt werden. Derartige Elektronikgehäuse sind meist modular aufgebaut, wobei die Elektronikgehäuse insbesondere nach dem Baukastenprinzip ausgeführt sind, so daß sich die einzelnen Gehäuseteile individuell und schnell zu einem optimalen Elektronikgehäuse zusammenstellen lassen. Häufig bestehen die Elektronikgehäuse aus einem Gehäuseoberteil und einem Gehäuseunterteil, wobei das Gehäuseoberteil Anschlüsse für elektrische Leitungen aufweist, die Anschlüsse über Steckerkontakte mit dem Gehäuseunterteil verbunden sind und das Gehäuseunterteil die Verbindung zu einem Bus-System herstellt. Ebenso kann das Elektronikgehäuse jedoch auch aus zwei seitlichen Gehäusehälften bestehen, die dann meist über Rastelemente miteinander verbunden werden. Die einzelnen Elektronikgehäuse sind dabei so ausgebildet, daß mehrere Elektronikgehäuse benachbart zueinander auf einer Tragschiene aufrastbar sind, so daß mehrere Elektronikgehäuse zusammen ein Elektronikgehäusesystem oder einen Elektronikgehäuseblock bilden. Dabei sind die einzelnen benachbarten Elektronikgehäuse bzw. die einzelnen benachbarten elektronischen Geräte vorzugsweise elektrisch miteinander kontaktierbar.

Bei der Montage der einzelnen Elektronikgehäuse auf der Tragschiene werden diese häufig entsprechend ihrer Zugehörigkeit zu einzelnen Maschinen oder Anlagen angeordnet, so daß einzelne, den jeweiligen Anlagen oder Maschinen zugeordnete Elektronikgehäusesysteme entstehen. Dabei sollen die einzelnen benachbarten Elektronikgehäuse, insbesondere dann, wenn sie auch elektrisch miteinander verbunden sind, auch mechanisch zu einem festen Block zusammengefügt werden können. Ein solcher fester Block bzw. ein Elektronikgehäusesystem, bei dem die einzelnen Elektronikgehäuse mechanisch miteinander verbunden sind, hat darüber hinaus den Vorteil, daß das Elektronikgehäusesystem als ganzes auf die Tragschiene aufgerastet oder von dieser abgehoben werden kann. Soll beispielsweise eine einmal an ein Elektronikgehäusesystem angeschlossene Maschine abgebaut und an einem anderen Standort wieder angeschlossen werden, so besteht dann, wenn auch das Elektronikgehäusesystem als ganzes von einer Tragschiene abgehoben und auf eine andere Tragschiene aufgerastet wird, nicht die Gefahr, daß es bei der Zuordnung einzelner Elektronikgehäuse zu einem Vertauschen derselben kommen kann.

Die Befestigung der einzelnen Elektronikgehäuse zu einem Elektronikgehäusesystem erfolgt dabei im Stand der Technik dadurch, daß die einzelnen Elektronikgehäuse mit Hilfe einer entsprechend langen Schraube und einer Mutter zusammengeschraubt werden. Ebenso können die einzelnen Elektronikgehäuse durch die Verwendung einer Abdeckhaube mit einer entsprechenden Länge zusammengehalten werden. Nachteilig ist dabei jedoch, daß für Elektronikgehäusesysteme mit einer unterschiedlichen Anzahl von Elektronikgehäusen jeweils unterschiedliche Schrauben oder Abdeckhauben mit einer entsprechenden Länge benötigt werden. Darüber hinaus besteht der Nachteil, daß dann, wenn bei einem Elektronikgehäusesystem ein neues Elektronikgehäuse hinzugefügt werden soll, die Befestigung des neuen Elektronikgehäusesystems mit derselben Schraube bzw. mit derselben Abdeckung nicht mehr möglich ist.

Die DE 1 871 657 U offenbart ein eingangs beschriebenes Elektronikgehäusesystem mit einem Anfangsstück, einem Endstück und einem Bolzen als Schlüsselelement. Bei dem bekannten Elektronikgehäusesystem erfolgt die Verbindung von mehr als drei Elektronikgehäuse miteinander dadurch, daß der an einem Ende des Bolzens ausgebildete Querstift in dem Mundstück des gegenüberliegenden Endes des Bolzens der nächsten Baugruppe verriegelt wird. Zur Verriegelung mehrerer Elektronikgehäuse ist es bei dem bekannten Verriegelungssystem somit erforderlich jedes Schlüsselelement auf der einen Seite mit einem Querstift und auf der anderen Seite mit einem Mundstück zu versehen, wobei das Mundstück eine Öffnung und eine Nut aufweisen muß.

Somit ist die Herstellung des Bolzens, insbesondere des unterfrästen Mundstücks, relativ aufwendig, wobei der Bolzen zusätzlich noch über eine Spiralfeder axial beweglich in dem Führungsstück geführt wird Durch die funktionsnotwendige Ausbildung des Mundstücks mit einer Öffnung, in die das mit dem Querstift versehene Ende eines anderen Bolzens einsteckbar ist, und der auf der Unterseite des Mundstücks angeordneten Nut, ergibt sich insgesamt ein Schlüsselelement mit einem relativ großen Durchmesser.

Der vorliegenden Erfindung liegt somit die Aufgabe zugrunde, ein eingangs beschriebenes Elektromkgehäusesystem zur Verfügung zu stellen, bei dem die Verriegelung der einzelnen Elektronikgehäuse möglichst leicht und flexibel möglich ist und bei dem das Schlüsselelement möglichst klein und einfach herstellbar ist.

Diese Aufgabe ist bei dem erfindungsgemäßen Elektronikgehäusesystem dadurch gelöst, daß zwischen dem Anfangsstück und dem Endstück mindestens ein in einem dritten Elektronikgehäuse angeordnetes Zwischenstück angeordnet ist, wobei das Zwischenstück ein Endstück und ein Anfangsstück aufweist und wobei in dem Endstück des Zwischenstücks das Ende eines ersten Schlüsselelements verriegelbar ist und in dem Anfangsstück des Zwischenstückes der Zylinderkopf eines zweiten Schlüsselelements versenkbar ist.

Das Zwischenstück dient somit funktional bezüglich des ersten Elektronikgehäuses, welches das Anfangsstück aufweist, als Endstück und bezüglich des zweiten Elektronikgehäuses, welches das Endstück aufweist, als Anfangsstück. Durch eine derartige Ausbildung des Zwischenstücks besteht die Möglichkeit, eine beliebige Anzahl von Zwischenstücken hintereinander zu schalten, wobei die einzelnen Zwischenstücke und damit die einzelnen Elektronikgehäuse jeweils mit einem identischen Schlüsselelement mechanisch miteinander verbunden werden können. Es ist somit eine kaskadierbare Verriegelung von beliebig vielen Elektronikgehäusen zu einem Elektronikgehäusesystem möglich, wobei zum einen das bestehende Elektronikgehäusesystem problemlos um einzelne Elektronikgehäuse verringert oder vergrößert werden kann und zum anderen beim Lösen eines Elektronikgehäuses von dem Elektronikgehäusesystem die verbleibenden Elektronikgehäuse nach wie vor miteinander befestigt sind.

Bei dem erfindungsgemäßen Elektronikgehäusesystem können somit n Elektronikgehäuse dadurch miteinander verbunden werden, daß das Verriegelungssystem aus einem Anfangsstück, einem Endstück, (n-2) Zwischenstücken und (n-1) Schlüsselelementen besteht. Vorteilhaft erweise sind das Anfangsstück oder das Endstück oder ein Zwischenstück in einer Ecke je eines Elektronikgehäuses angeordnet, wobei das Anfangsstück, das Endstück und das Zwischenstück jeweils einteilig mit einem Elektronikgehäuse ausgebildet sind. Soll eine besonders sichere Verbindung von mehreren Elektronikgehäusen zu einem Elektronikgehäusesystem gewährleistet sein, so sind in mindestens zwei Ecken der Elektronikgehäuse je ein Anfangsstück oder ein Endstück oder ein Zwischenstück angeordnet.

Obwohl das zuvor beschriebene Verriegelungssystem zunächst und im wesentlichen dafür geeignet ist, zwei Elektronikgehäuse miteinander zu verbinden, so kann es auch dafür eingesetzt werden, zwei Gehäusehälften eines Elektronikgehäuses miteinander zu verriegeln. Dann befindet sich in der einen Gehäusehälfte das Anfangsstück und in der anderen Gehäusehälfte das Endstück des Verriegelungssystems.

Gemäß einer vorteilhaften Ausgestaltung der Erfindung weist das Schlüsselelement einen Zylinderkopf mit mindestens einem Schlitz zur Drehbetätigung auf. Ein solches Schlüsselelement kann relativ klein, vorzugsweise mit einem Zylinderkopf mit Gewindegröße M 3 ausgeführt werden, wobei durch die Anordnung des Schlitzes in dem Zylinderkopf das Schlüsselelement trotzdem leicht betätigt werden kann, beispielsweise mit der Spitze eines Schraubendrehers. Durch entsprechende Ausgestaltung des Schlitzes kann dafür gesorgt werden, daß das Schlüsselelement nur mit einem Spezialwerkzeug betätigt werden kann, so daß das Lösen eines Elektronikgehäusesystems durch Unbefugte verhindert wird.

Gemäß einer vorteilhaften Ausgestaltung des erfindungsgemäßen Elektronikgehäusesystems ist im Anfangsstück eine Sackbohrung zur Abstützung des Zylinderkopfes des Schlüsselelements ausgebildet. Hierdurch kann zum einen gewährleistet werden, daß der Zylinderkopf des Schlüsselelements in Anfangsstück versenkbar ist, zum anderen dafür gesorgt werden, daß das Schlüsselelement stets so weit in das Anfangsstück hineingesteckt wird, daß das Ende des Schlüsselelements mit dem Endstück in Eingriff gebracht werden kann. Dadurch, daß der Zylinderkopf des Schlüsselelements in dem Anfangsstück versenkbar ist, können die Elektronikgehäuse direkt benachbart zueinander angeordnet werden.

Das Ende des Scblüsselelements ist bevorzugt als Schlüsselbart ausgebildet, wobei dann das Endstück des Verriegelungssystems ein zu dem Schlüsselbart des Schlüsselelements korrespondierendes Schloß aufweist Daneben ist jedoch auch eine Verriegelung des Schlüsselelements in dem Endstück nach Art einer Bajonettverbindung möglich.

Im einzelnen gibt es nun eine Vielzahl von Möglichkeiten, das erfindungsgemäße Elektronikgehäuse auszugestalten und weiterzubilden. Dazu wird verwiesen auf die dem Patentanspruch I nachgeordneten Patentansprüche sowie auf die Beschreibung bevorzugter Ausführungsbeispiele in Verbindung mit der Zeichnung. In der Zeichnung zeigen
- Fig. 1: ein Ausführungsbeispiel eines nicht zur Erfindung gehörenden Verriegelungsstems eines Elektronikgehäusesystems mit nur zwei Gehäusestücken, dargestellt in vier Verriegelungsschritten,
- Fig. 2: eine Darstellung eines erfindungsgemäßen Verriegelungssystems mit drei Gehäusestücken.
- Fig. 3: ein Ausführungsbeispiel des erfindungsgemäßen Verriegelungssystems eines elektronikgehäusesystems mit sechs Gehäusestücken, dargestellt in zwei Verriegelungszuständen, und

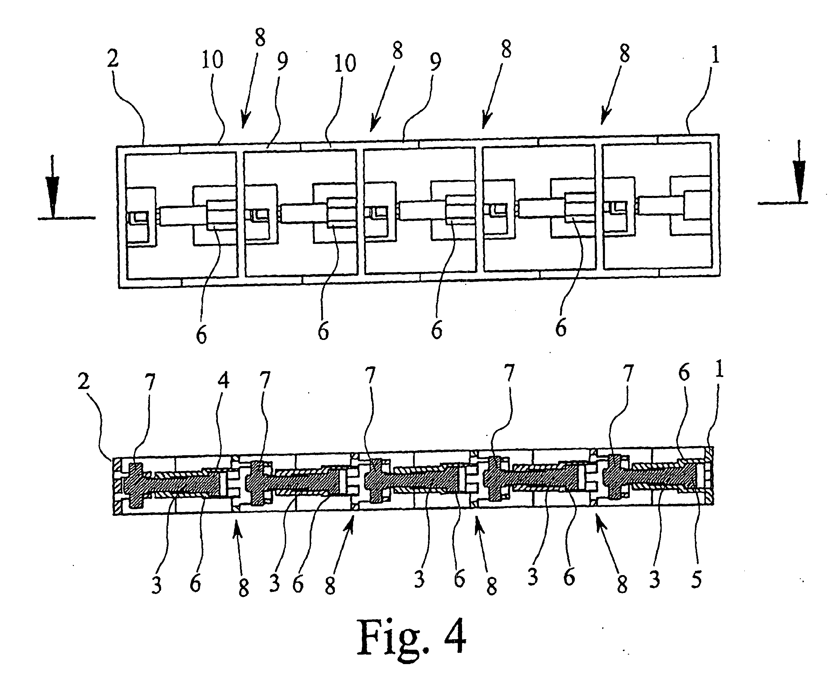

- Fig. 4: ein Ausführungsbeispiel des erfindungsgemäßen Verriegelungssystems eines Elektronikgehäusesystems gemäß Fig. 3, vollständig verriegelt, in Seitenansicht und im Schnitt.

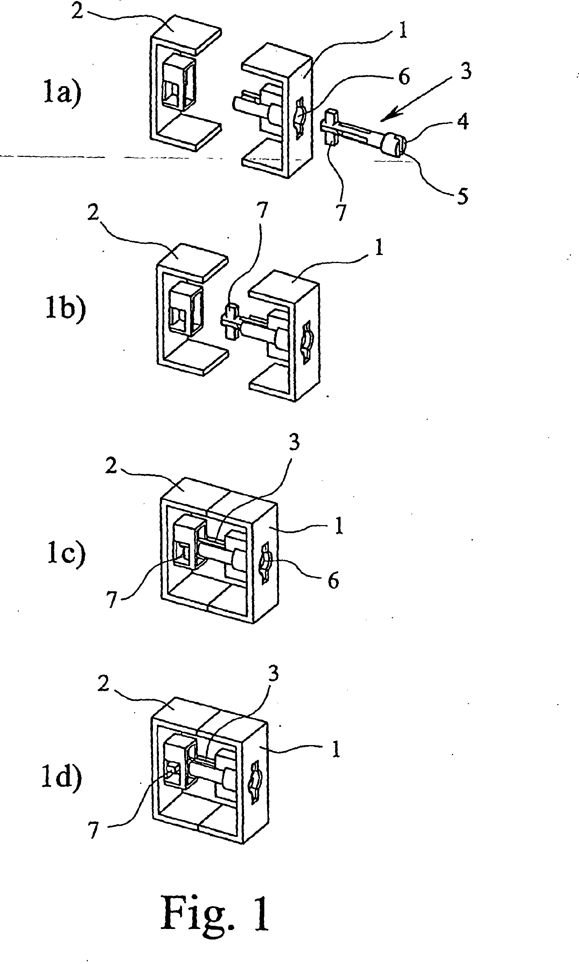

In den Figuren dargestellt ist nur ein Teil des erfindungsgemäßen Elektronikgehäusesystems, nämlich jeweils nur das eigentliche Verriegelungssystem, welches aus mindestens drei Gehäwestücken besteht, die ihrerseits jeweils Teil eines Elektronikgehäuses sind. Die in den Fig. 1 bis 3 dargestellten Ausführungsbeispiele des Verriegelungssystems unterscheiden sich dadurch, daß jeweils eine unterschiedliche Anzahl von Elektronikgehäusen mit Hilfe des Verriegelungssystems zu einem Elektronikgehäusesystem zusammengeschlossen werden können.

Das in Fig. 1 dargestellte Verriegelungssystem besteht aus nur zwei Gehäusestücken, nämlich einem Anfangsstück 1 und einem Endstück 2, so daß mit diesem Verriegelungssystem auch nur zwei Elektronikgehäuse zusammengeschlossen werden können. Zu dem Verriegelungssystem gehört darüber hinaus noch ein Schlüsselelement 3. Das Schlüsselelement 3 kann in das als Schlüsselaufnahme ausgebildete Anfangsstück 1 eingesteckt und durch eine Drehung in dem als Schloß ausgebildeten Endstück 2 verriegelt werden. Hierbei handelt es sich nicht um ein Ausführungsbeispiel der Erfindung, sondern die Fig. 1 soll nur das Verständnis der Erfindung erleichtern.

Das Schlüsselelement 3 weist einen Zylinderkopf 4 mit einem Schlitz 5 zur Drehbetätigung des Schlusselelements 3 auf. Durch die Ausbildung des einen Endes des Schlüsselelements 3 als Zylinderkopf 4 und die Anordnung eines Schlitzes 5 in dem Zylinderkopf 4 kann das Schlüsselelement 3 als sehr kleines Bauteil hergestellt werden, beispielsweise der Zylinderkopf 4 lediglich Gewindegröße M 3 aufweisen. Durch die Anordnung des Schlitzes 5 in dem Zylinderkopf 4 ist das Schlüsselelement 3 auch bei derart geringen Abmessungen noch einfach betätigbar, beispielsweise mit Hilfe der Spitze eines Schraubendrehers.

Darüber hinaus besteht die Möglichkeit, daß das Schlüsselelement 3 mit seinem Zylinderkopf 4 im Anfangsstück 1 vollständig versenkbar ist. Hierzu ist im Anfangsstück 1 eine Sackbohrung 6 ausgebildet, die auch zur Abstützung des Zylinderkopfes 4 des Schlüsselelements 3 dient. Das andere Ende des Schlüsselelements 3 ist als Schlüsselbart 7 ausgebildet, so daß das Schlüsselelement 3 durch eine einfache Drehung um beispielsweise 90° in dem Endstück 2 verriegelt werden kann.

Anhand der Fig. 1a bis 1d sind die einzelnen Verriegelungsschritte des erfindungsgemäßen Verriegelungssystems leicht erkennbar. Zunächst sind gemäß Fig. 1a das Anfangsstück 1, das Endstück 2 und das Schlüsselelement 3 vollständig voneinander separiert, d. h. ein erstes Elektronikgehäuse, in dem das Anfangsstück 1 angeordnet ist, und ein zweites Elektronikgehäuse, in dem das Endstück 2 angeordnet ist, sind noch nicht miteinander verbunden. In einem ersten Verriegelungsschritt wird nun - wie in Fig. 1b dargestellt - das Schlüsselelement 3 in das Anfangsstück 1 eingesteckt. Hierbei befindet sich der Schlüsselbart 7 des Schlüsselelements 3 in einer senkrechten Position. Ist das Schlüsselelement 3 vollständig in das Anfangsstück 1 eingeschoben, so stützt sich der Zylinderkopf 4 des Schlüsselelements 3 im Inneren des Anfangsstück 1 an der Sackbohrung 6 ab und ist vollständig in dem Anfangsstück 1 versenkt. In einem dritten Schritt werden nun das Anfangsstück 1 und das Endstück 2, d. h. das erste Elektronikgehäuse und das zweite Elektronikgehäuse, zusammengeschoben, so daß der Schlüsselbart 7 des Schlüsselelements 3 in dem als Schloß ausgebildeten Endstück 2 eingreift. Das Anfangsstück 1 und das Endstück 2 sind nun zwar schon zusammengesteckt (Fig. 1c), sie sind jedoch noch nicht miteinander verriegelt, so daß auch die beiden Elektronikgehäuse noch nicht miteinander verriegelt sind. In einem letzten Verriegelungsschritt wird nun der Schlüsselbart 7 des Schlüsselelements um ca. 90° gedreht, wodurch der Schlüsselbart 7 derart in dem Endstück 2 angeordnet ist, daß das Schlüsselelement 3 in dieser Position nicht mehr herausgezogen werden kann. Dadurch, daß der Zylinderkopf 4 des Schlüsselelements 3 in der Sackbohrung 6 des Anfangsstücks 1 anliegt, ist nun auch das Anfangsstück 1 mit dem Endstück 2 verriegelt.

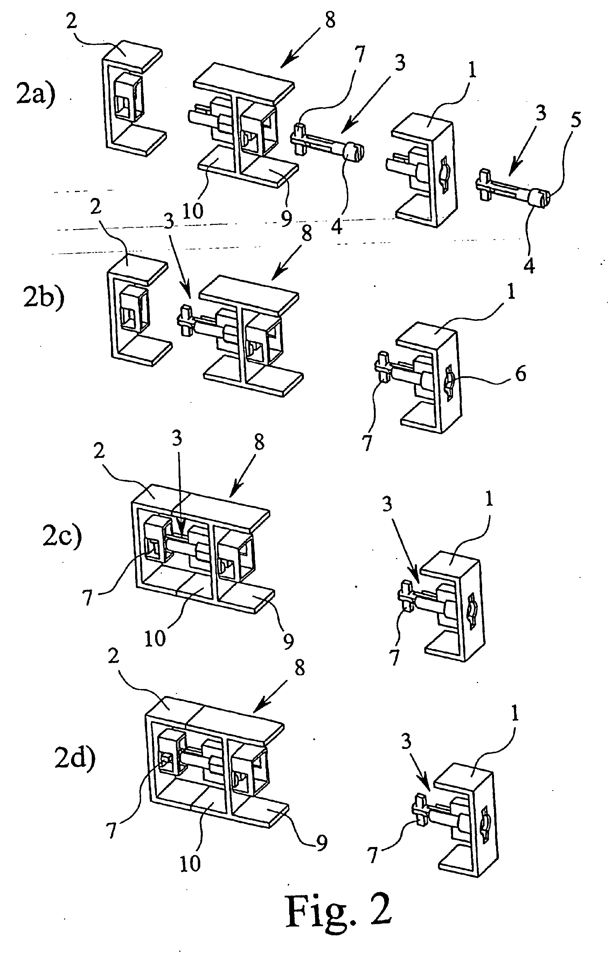

Das in Fig. 2 dargestellte erfindungsgemäße Verriegelungssystem unterscheidet sich von dem zuvor beschriebenen Verriegelungssystem gemäß Fig. 1 dadurch, daß es aus drei Gehäusestücken, nämlich einem Anfangsstück 1, einem Endstück 2 und zusätzlich einem Zwischenstück 8 besteht. Mit dem in Fig. 2 dargestellten Verriegelungssystem können somit drei Elektronikgehäuse zu einem Elektronikgehäusesystem zusammengeschlossen werden.

Das Zwischenstück 8 ist nun so ausgebildet, daß es aus einem Endstück 9 und einem Anfangsstück 10 besteht, wobei in dem Anfangsstück 10 der Zylinderkopf 4 eines ersten Schlüsselelements 3 versenkbar ist und in dem Endstück 9 der Schlüsselbart 7 eines zweiten Schlüsselelements 3 verriegelbar ist. Dabei ist das Endstück 9 des Zwischenstücks 8 genauso ausgebildet wie das separate Endstück 2. Ebenso ist das Anfangsstück 10 des Zwischenstücks 8 entsprechend dem separaten Anfangsstück 1 ausgebildet und weist ebenso wie das Anfangsstück 1 eine Sackbohrung 6 zur Aufnahme des Zylinderkopfes 4 eines Schlüsselelements 3 auf. Ein Vergleich der Fig. 1 und 2 zeigt, daß das Anfangsstück 1 entweder direkt oder durch Zwischenschaltung des Zwischenstücks 8 mit dem Endstück 2 verbunden werden kann.

Die Fig. 2a bis 2d zeigt nun, wie die Fig. 1a bis 1d, verschiedene Verriegelungsschritte. Zunächst wird das Zwischenstück 8 mit dem Endstück 2 verriegelt, wozu ein erstes Schlüsselelement 3 durch das Endstück 9 hindurch in das Anfangsstück 10 geschoben wird, bis der Zylinderkopf 4 des Schlüsselelements 3 in der Sackbohrung 6 im Anfangsstück 10 anliegt (Fig. 2b). Anschließend werden das Zwischenstück 8 und das Endstück 2 zusammengeschoben (Fig. 2c) und sodann das Zwischenstück 8 mit dem Endstück 2 verriegelt, indem der Schlüsselbart 7 des ersten Schlüsselelements 3 um ca. 90° gedreht wird (Fig. 2d). Als letztes wird dann das Anfangsstück 1 mit dem Zwischenstück 8 verbunden, wozu zunächst ein zweites Schlüsselelement 3 in das Anfangsstück 1 eingeschoben wird und anschließend das Anfangsstück 1 mit dem Endstück 9 des Zwischenstücks 8 zusammengesteckt und durch Drehung des Schlüsselbarts 7 des zweiten Schlüsselelements 3 verriegelt wird.

Aus Fig. 2 ist somit erkennbar, daß die Verriegelung des Zwischenstücks 8 mit dem Endstück 2 bzw. des Anfangsstück 1 mit dem Zwischenstück 8 auf die gleiche Art und Weise erfolgt, wie die in Fig. 1 dargestellte Verriegelung von Anfangsstück 1 und, Endstück 2. Unabhängig davon, ob nur ein Anfangsstück 1 und ein Endstück 2, d. h. nur zwei Elektronikgehäuse miteinander verbunden werden sollen, oder ob ein Anfangsstück 1, ein Zwischenstück 8 und ein Endstück 2, d. h. drei Elektronikgehäuse miteinander verbunden werden sollen, werden jeweils die gleichen Schlüsselelemente 3 benötigt, wobei im ersten Fall nur ein Schlüsselelement 3 und im zweiten Fall zwei Schlüsselelemente 3 benötigt werden.

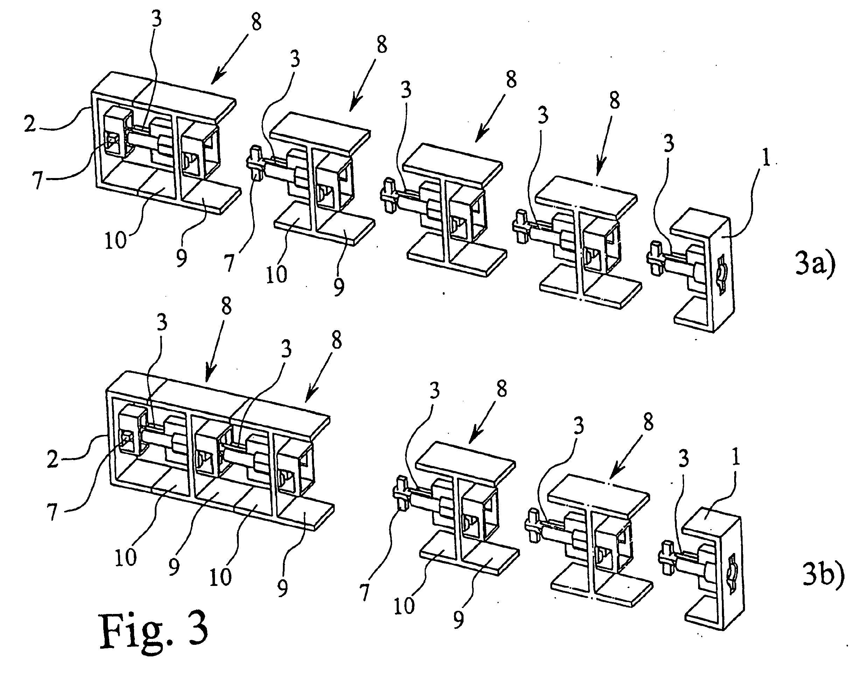

Fig. 3 zeigt nun als weiteres Ausführungsbeispiel ein Verriegelungssystem zur Verriegelung von insgesamt sechs Elektronikgehäusen, wobei je ein Elektronikgehäuse ein Anfangsstück 1 und ein Endstück 2 aufweisen, und in vier Elektronikgehäusen je ein Zwischenstück 8 ausgebildet ist. Die Verriegelung eines solchen Elektronikgehäusesystems mit Hilfe eines derartigen Verriegelungssystems erfolgt nun wiederum schrittweise, so daß zunächst das Endstück 2 mit dem ersten (in Fig. 3 ganz links dargestellten) Zwischenstück 8 verriegelt wird. Hierzu wird in das Anfangsstück 9 des ersten Zwischenstücks 8 ein erstes Schlüsselelement 3 eingesteckt und nach dem Zusammenstecken des Endstücks 2 mit dem ersten Zwischenstück 8 der Schlüsselbart 7 des Schlüsselelements 3 durch eine 90°-Drehung in dem Endstück 2 verriegelt. Als nächstes wird dann ein zweites Zwischenstück 8 mit dem ersten Zwischenstück 8 verriegelt, wobei dann ein zweites Schlüsselelement 3 das Anfangsstück 10 des zweiten Zwischenstücks 8 mit dem Endstück 9 des ersten Zwischenstücks 8 zusammenhält. Ebenso wird anschließend das dritte Zwischenstück 8 mit dem zweiten Zwischenstück 8 und das vierte Zwischenstück 8 mit dem dritten Zwischenstück 8 verbunden. Als letztes wird dann das Anfangsstück 1 mit dem vierten Zwischenstück 8 zusammengeschlossen.

In Fig. 3 ist das vierte Zwischenstück 8 gestrichelt dargestellt, um anzudeuten, daß das Verriegelungssystem um weitere Zwischenstücke ergänzt werden kann. Mit dem erfindungsgemäßen Verriegelungssystem ist somit eine kaskadierbare Verriegelung von beliebig vielen Elektronikgehäusen zu einem Elektronikgehäusesystem möglich, wobei die Anzahl der miteinander verriegelten Elektronikgehäuse jederzeit erhöht oder verringert werden kann. So können mit dem Verriegelungssystem also n Elektronikgehäuse mechanisch fest miteinander verbunden werden, wozu das Verriegelungssystem ein Anfangsstück 1, ein Endstück 2, (n-2) Zwischenstücke 8 und (n-1) Schlüsselelemente 3 aufweist. Besonders einfach ist das erfindungsgemäße Verriegelungssystem auch dadurch herzustellen, daß sowohl die einzelnen Zwischenstücke 8 als auch die einzelnen Schlüsselelemente 3, unabhängig von der Anzahl der zu verriegelnden Elektronikgehäuse, identisch ausgebildet sind.

Dadurch, daß die Zwischenstücke 8 jeweils ein Endstück 9 und ein Anfangsstück 10 aufweisen, ist es darüber hinaus auch möglich, eine beliebige Anzahl von Elektronikgehäusen zu einem Elektronikgehäusesystem zusammenzuschließen, wobei jedes Elektronikgehäuse identisch aufgebaut ist, nämlich jeweils mindestens ein Zwischenstück 8 aufweist. Bei einem solchen Elektronikgehäusesystem würde dann das Anfangsstück 10 des ersten Zwischenstücks 8 und das Endstück 9 des letzten Zwischenstücks 8 nicht benutzt werden. Ein seperates Anfangsstück 1 und ein seperates Endstück 2 sind dann nicht erforderlich.

## Patentansprüche

1. Elektronikgehäusesystem mit mindestens drei, insbesondere scheibenförmigen, auf einer Tragschiene aufrastbaren Elektronikgehäusen, mit einem Verriegelungssystem zur Verriegelung der einzelnen Elektronikgehäuse, bestehend aus mindestens zwei Gehäusestücken, nämlich einem in dem ersten Elektronikgehäuse angeordneten Anfangsstück (1) und einem in einem zweiten Elektronikgehäuse angeordneten Endstück (2), und aus einem Schlüsselelement (3), mit einem zylinderkopf wobei das Anfangsstück (1) als Schlüsselaufnahme und das Endstück (2) als Schloß ausgebildet ist und die beiden Gehäusestücke durch eine Drehung des Schlüsselelements (3) in dem Endstück (2) miteinander verriegelbar sind,
**dadurch gekennzeichnet,**
**daß** zwischen dem Anfangsstück (1) und dem Endstück (2) mindestens ein in einem dritten Elektronikgehäuse angeordnetes Zwischenstück (8) angeordnet ist, wobei das Zwischenstück (8) ein Endstück (9) und ein Anfangsstück (10) aufweist und
wobei in dem Endstück (9) des Zwischenstücks (8) das Ende eines ersten Schlüsselelements (3) verriegelbar ist und in dem Anfangsstück (10) des Zwischenstückes (8) der Zylinderkopf (4) eines zweiten Schlüsselelements (3) versenkbar ist.

2. Elektronikgehäusesystem nach Anspruch 1, **dadurch gekennzeichnet, daß** das Schlüsselelement (3) einen Zylinderkopf (4) mit mindestens einem Schlitz (5) zur Drehbetätigung aufweist.

3. Elektronikgehäusesystem nach Anspruch 2, **dadurch gekennzeichnet, daß** in dem Anfangsstück (1) der Zylinderkopf (4) eines Schlüsselelements (3) versenkbar ist.

4. Elektronikgehäusesystem nach Anspruch 2 oder 3, **dadurch gekennzeichnet, daß** im Anfangsstück (1) oder im Anfangsstück (10) des Zwischenstücks (8) eine Sackbohrung (6) zur Abstützung des Zylinderkopfs (4) des Schlüsselelements (3) ausgebildet ist.

5. Elektronikgehäusesystem nach einem der Ansprüche 1 bis 4, **dadurch gekennzeichnet, daß** das Ende des Schlüsselelements (3) als Schlüsselbart (7) ausgebildet ist

6. Elektronikgehäusesystem nach einem der Ansprüche 1 bis 5 mit n Elektronikgehäusen, **dadurch gekennzeichnet, daß** das Verriegelungssystem aus einem Anfangsstück (1), einem Endstück (2), (n - 2) Zwischenstücken (8) sowie (n - 1) Schlüsselelementen (3) besteht.

7. Elektronikgehäusesystem nach einem der Ansprüche 1 bis 6, **dadurch gekennzeichnet, daß** ein Anfangsstück (1), ein Endstück (2) oder ein Zwischenstück (8) in einer Ecke des Elektronikgehäuse angeordnet ist, daß insbesondere das Anfangsstück (1), das Endstück (2) und das Zwischenstück (8) jeweils einteilig mit dem Elektronikgehäuse ausgebildet sind.

8. Elektronikgehausesystem nach einem der Ansprüche 1 bis 7, **dadurch gekennzeichnet, daß** mehrere Anfangsstücke (1) oder mehrere Endstücke (2) oder mehrere Zwischenstücke (8) jeweils Teil des Elektronikgehäuses sind, insbesondere in mindestens zwei Ecken der Elektronikgehäuse je ein Anfangsstück (1) oder ein Endstück (2) oder ein Zwischenstück (8) angeordnet sind.

## Claims

1. Electronics housing system having at least three, in particular disc-shaped electronics housings which can be latched onto a mounting rail, having a locking system for the purpose of locking the individual electronics housings, comprising at least two housing pieces, namely a starting piece (1), arranged in the first electronics housing, and an end piece (2), arranged in a second electronics housing, and comprising a key element (3) having a cylinder head, the starting piece (1) being in the form of a key receptacle, and the end piece (2) being in the form of a lock, wherein the two housing pieces can be be locked to one another by rotating the key element (3) in the end piece (2),
**characterized in**
**that** at least one intermediate piece (8), which is arranged in a third electronics housing, is arranged between the starting piece (1) and the end piece (2), the intermediate piece (8) having an end piece (9) and a starting piece (10),
and wherein the end of a first key element (3) can be locked in the end piece (9) of the intermediate piece (8) and the cylinder head (4) of a second key element (3) can be sunk into the starting piece (10) of the intermediate piece (8).

2. Electronics housing system according to claim 1, **characterized in that** the key element (3) has a cylinder head (4) having at least one slot (5) for rotary actuation purposes.

3. Electronics housing system according to claim 2, **characterized in that** the cylinder head (4) of a key element (3) can be sunk into the starting piece (1).

4. Electronics housing system according to claim 2 or 3, **characterized in that** a blind hole (6) is formed in the starting piece (1) or in the starting piece (10) of the intermediate piece (8) for the purpose of supporting the cylinder head (4) of the key element (3).

5. Electronics housing system according to one of claims 1 to 4, **characterized in that** the end of the key element (3) is in the form of a key bit (7).

6. Electronics housing system according to one of claims 1 to 5 having n electronics housings, **characterized in that** the locking system comprises a starting piece (1), an end piece (2), (n-2) intermediate pieces (8) and (n-1) key elements (3).

7. Electronics housing system according to one of claims 1 to 6, **characterized in that** a starting piece (1), an end piece (2) or an intermediate piece (8) is arranged in a corner of the electronics housing, and wherein, in particular, the starting piece (1), the end piece (2) and the intermediate piece (8) are each designed to be integral with the electronics housing.

8. Electronics housing system according to one of claims 1 to 7, **characterized in that** two or more starting pieces (1) or two or more end pieces (2) or two or more intermediate pieces (8) are each part of the electronics housing, in particular in each case one starting piece (1) or one end piece (2) or one intermediate piece (8) is arranged in at least two corners of the electronics housing.

## Revendications

1. Système de boîtier électronique comprenant au moins trois boîtiers électroniques, notamment en forme de plaques, pouvant être emboîtés sur un rail de support, comprenant un système de verrouillage pour verrouiller les boîtiers électroniques individuels, se composant d'au moins deux parties de boîtier, à savoir une partie antérieure (1) disposée dans le premier boîtier électronique et une partie postérieure (2) disposée dans le deuxième boîtier électronique, et d'un élément de clé (3) avec une tête cylindrique, la partie antérieure (1) étant réalisée en tant que logement de clé et la partie postérieure (2) en tant que serrure, et les deux parties de boîtier pouvant être verrouillées l'une à l'autre par une rotation de l'élément de clé (3) dans la partie postérieure (2),
**caractérisé en ce qu'**
au moins une partie intermédiaire (8) disposée dans un troisième boîtier électronique est disposée entre la partie antérieure (1) et la partie postérieure (2), la partie intermédiaire (8) présentant une partie postérieure (9) et une partie antérieure (10) et
l'extrémité d'un premier élément de clé (3) pouvant être verrouillée dans la partie postérieure (9) de la partie intermédiaire (8) et la tête cylindrique (4) d'un deuxième élément de clé (3) pouvant être enfoncée dans la partie antérieure (10) de la partie intermédiaire (8).

2. Système de boîtier électronique selon la revendication 1, **caractérisé en ce que** l'élément de clé (3) présente une tête cylindrique (4) avec au moins une fente (5) pour l'actionnement en rotation.

3. Système de boîtier électronique selon la revendication 2, **caractérisé en ce que** la tête cylindrique (4) d'un élément de clé (3) peut être enfoncée dans la partie antérieure (1).

4. Système de boîtier électronique selon la revendication 2 ou 3, **caractérisé en ce qu'**un alésage borgne (6) est réalisé dans la partie antérieure (1) ou dans la partie antérieure (10) de la partie intermédiaire (8) pour supporter la tête cylindrique (4) de l'élément de clé (3).

5. Système de boîtier électronique selon l'une quelconque des revendications 1 à 4, **caractérisé en ce que** l'extrémité de l'élément de clé (3) est réalisé sous forme de panneton (7).

6. Système de boîtier électronique selon l'une quelconque des revendications 1 à 5, comprenant n boîtiers électroniques, **caractérisé en ce que** le système de verrouillage se compose d'une partie antérieur (1), d'une partie postérieure (2), de (n-2) parties intermédiaires (8) ainsi que de (n-1) éléments de clé (3).

7. Système de boîtier électronique selon l'une quelconque des revendications 1 à 6, **caractérisé en ce qu'**une partie antérieure (1), une partie postérieure (2) ou une partie intermédiaire (8) est disposée dans un coin du boîtier électronique, **en ce que** notamment la partie antérieure (1), la partie postérieure (2) et la partie intermédiaire (8) sont à chaque fois réalisées d'une seule pièce avec le boîtier électronique.

8. Système de boîtier électronique selon l'une quelconque des revendications 1 à 7, **caractérisé en ce que** plusieurs parties antérieures (1) ou plusieurs parties postérieures (2) ou plusieurs parties intermédiaires (8) font chacune partie du boîtier électronique, notamment à chaque fois une partie antérieure (1), ou une partie postérieure (2) ou une partie intermédiaire (8) sont disposées dans au moins deux coins du boîtier électronique.
